(19) Europäisches Patentamt
European Patent Office
Office européen des brevets

(11) **EP 2 453 489 A1**

(12) **EUROPEAN PATENT APPLICATION**
published in accordance with Art. 153(4) EPC

(43) Date of publication:
**16.05.2012 Bulletin 2012/20**

(21) Application number: **10797107.9**

(22) Date of filing: **05.07.2010**

(51) Int Cl.:
*H01L 33/50* (2010.01)     *H01L 33/00* (2010.01)
*H05B 37/02* (2006.01)

(86) International application number:
**PCT/JP2010/061424**

(87) International publication number:
**WO 2011/004796 (13.01.2011 Gazette 2011/02)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **07.07.2009   JP 2009161132**

(71) Applicant: **CCS Inc.**
**Kyoto-City, Kyoto 602-8011 (JP)**

(72) Inventors:
• **MIYASAKA, Shin**
**Kyoto-city**
**Kyoto 602-8011 (JP)**
• **SUZUKI, Hirokazu**
**Kyoto-city**
**Kyoto 602-8011 (JP)**

(74) Representative: **Müller - Hoffmann & Partner**
**Patentanwälte**
**Innere Wiener Strasse 17**
**81667 München (DE)**

(54) **LIGHT EMITTING DEVICE**

(57)    To provide a light emitting device capable of favorably controlling a color temperature of white light and having excellent color rendering properties, the light emitting device includes: a plurality of kinds of LED elements emitting ultraviolet rays or short-wavelength visible rays of different wavelengths; a single wavelength converting member containing fluorescent substances and converting the ultraviolet rays or short-wavelength visible rays emitted from the plurality of kinds of LED elements to derive white light; and a current control part varying current values to be supplied to the plurality of kinds of LED elements.

FIG.1

EP 2 453 489 A1

## Description

### Technical Field

The present invention relates to a light emitting device capable of favorably controlling a color temperature of white light.

### Background Art

Conventionally, there has been known a light emitting device emitting white light using three kinds of LED elements of a red LED element, green LED element and blue LED element. In the case of using the light emitting device as an interior illumination, there is a desire of varying a color temperature of the white light to be cold white, mild-warm white and warm white according to circumstances in use.

In this case, it is preferable that the white light is varied while maintaining the color thereof as natural as possible. Therefore, it is attempted to vary the color temperature of the white light along a black-body locus or the vicinity thereof by adjusting supply currents to the three kinds of LED elements (Patent literature 1).

However, the three kinds of LED elements have different forward drop voltages ($V_f$), respectively, that are, approximately 2.0 V in a red LED element, approximately 3.3 V in a green LED element and approximately 3.4 V in a blue LED element. Therefore, in order to adjust a balance of light quantity under the condition that the different voltages are applied to the respective LED elements, a complicated operation process is required for adjusting the current amount supplied to the respective LED elements. For this reason, there is a problem that it is difficult to control the color temperatures of the white light.

Moreover, since each of the red LED element, the green LED element and the blue LED element has a narrow width of a wavelength of emission light, it is difficult to perform a control with high color rendering properties to smoothly vary the color temperatures of the white light from cold white to mild-warm white and to warm white.

### Citation List

### Patent Literature

Patent Literature 1: JP2004-6253A

### Summary of Invention

### Technical Problem

The present invention has been made considering the problems mentioned above and an essential object thereof is to provide a light emitting device capable of favorably controlling color temperatures of white light with excellent color rendering properties.

### Solution to Problem

That is, a light emitting device pertaining to the present invention includes: a plurality of kinds of LED elements emitting ultraviolet rays or short-wavelength visible rays of different wavelengths; a single wavelength converting member containing fluorescent substances and converting the ultraviolet rays or short-wavelength visible rays emitted from the plurality of kinds of LED elements to derive white light; and a current control part varying current values to be supplied to the plurality of kinds of LED elements. Herein, as the short-wavelength visible rays, there are exemplified such as violet light, blue light and green light, and neat ultraviolet rays are included in the ultraviolet rays.

With this configuration, since the ultraviolet rays or short-wavelength visible rays of different wavelengths emitted from the plurality of kinds of LED elements are converted by the same wavelength converting member, a plural kinds of white light having different color temperatures are favorably mixed inside the wavelength converting member so as to be able to obtain natural white light having a color temperature variable along a black-body locus or the vicinity thereof.

Further, according to the light emitting device pertaining to the present invention, since the color temperatures of the white light can be adjusted by a single package accommodating the plurality of kinds of LED elements, it becomes possible to miniaturize the light emitting device compared to the conventional light emitting device in which the color temperatures of the white light are adjusted using a plurality of kinds of packages respectively having different distributions of the fluorescent substances, and hence the manufacturing cost can be accordingly reduced.

As the LED elements mentioned above, in specific, each of the LED elements having a radiation peak at a wavelength of 200 to 430 nm is preferably used, more preferably each of the LED elements having a radiation peak in a wavelength range of 360 to 430 nm is exemplified.

Preferably, the plurality of kinds of LED elements are alternately (in a staggered manner) arranged on the same base member. By alternately arranging like this, the white light excited by the respective kinds of LED elements and emitted by the wavelength converting member are facilitated to be mixed so as to be able to favorably obtain white light having an intermediate color temperature of the color temperatures of these kinds of white light. Further, with this configuration, the light source positions can be uniformed.

As the fluorescent substances, fluorescent substances emitting red light (referred to as "red fluorescent substances" hereinafter), fluorescent substances emitting green light (referred to as "green fluorescent substances" hereinafter) and fluorescent substances emitting blue light (referred to as "blue fluorescent substances" hereinafter) are preferably used. An excitation efficiency of the blue fluorescent substances (i.e., conversion efficiency to blue light) differs according to a wavelength of the ultraviolet rays or short-wavelength visible rays serving as excitation light, and the green fluorescent substances are also excited by the blue light in addition to the ultraviolet rays or short-wavelength visible rays, and the red fluorescent substances are also excited by the blue light and green light in addition to the ultraviolet rays or short-wavelength visible rays. Therefore, if the blue fluorescent substances, green fluorescent substances and red fluorescent substances are used in combination, as the light intensity of the blue light emitted from the blue fluorescent substances is varied, the light intensities of the green and red light emitted from the green and red fluorescent substances are also varied, and therefore the natural white light having different color temperatures can be obtained. Hence, by mixing these kinds of light, there can be obtained the white light having the color temperature varying along the black-body locus or the vicinity thereof. Herein, even though only the light intensity of the blue light is varied, there cannot be obtained white light having a color temperature varying along the black-body locus or the vicinity thereof. Advantageous Effects of Invention

According to the present invention as described above, since the color temperature of the white light can be varied along the black-body locus or the vicinity thereof, there can be obtained a light emitting device having excellent color rendering properties.

Brief Description of Drawings

[Fig. 1] Fig. 1 is a schematic configuration diagram of a light emitting device pertaining to one embodiment of the present invention.
[Fig. 2] Fig. 2 is a plan view of an LED package in the same embodiment.
[Fig. 3] Fig. 3 is a longitudinal section view of the LED package in the same embodiment.
[Fig. 4] Fig. 4 is a flowchart showing a method of adjusting a color temperature and light quantity of white light emitted by the light emitting device pertaining to the same embodiment.
[Fig. 5] Fig. 5 is a plan view of the LED package in another embodiment. Description of Embodiments

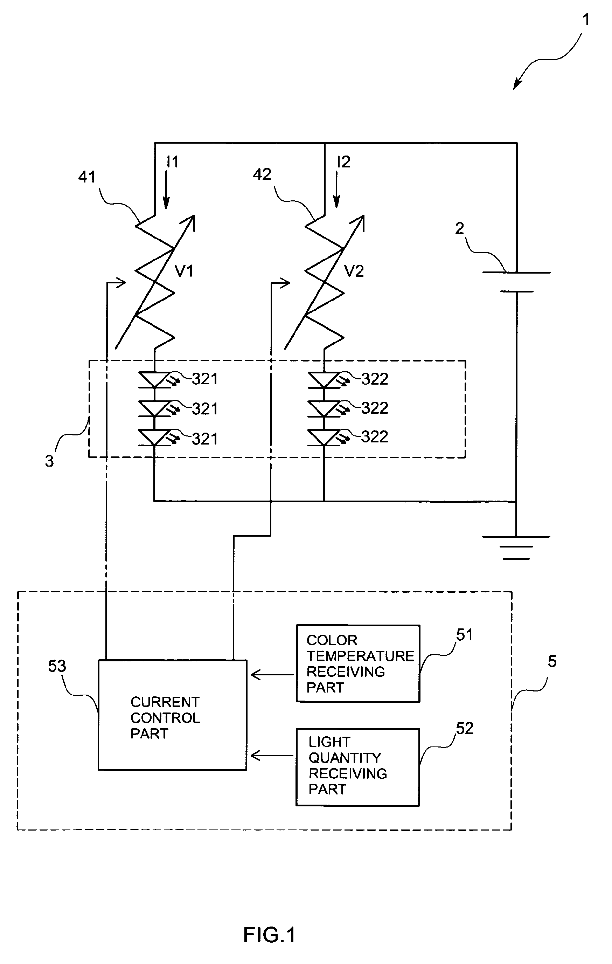

One embodiment of the present invention is described below according to the drawings.
As shown in Fig. 1, a light emitting device 1 pertaining to the present embodiment includes a power source 2, a LED package 3 provided with first LED elements 321 and second LED elements 322, variable resistors 41 and 42 respectively connected to the LED elements 321 and 322, and a control device 5.

The following describes each of parts in detail. The power source 2 is adapted to supply a voltage that is larger than drop voltages of the first LED elements 321 and the second LED elements 322.

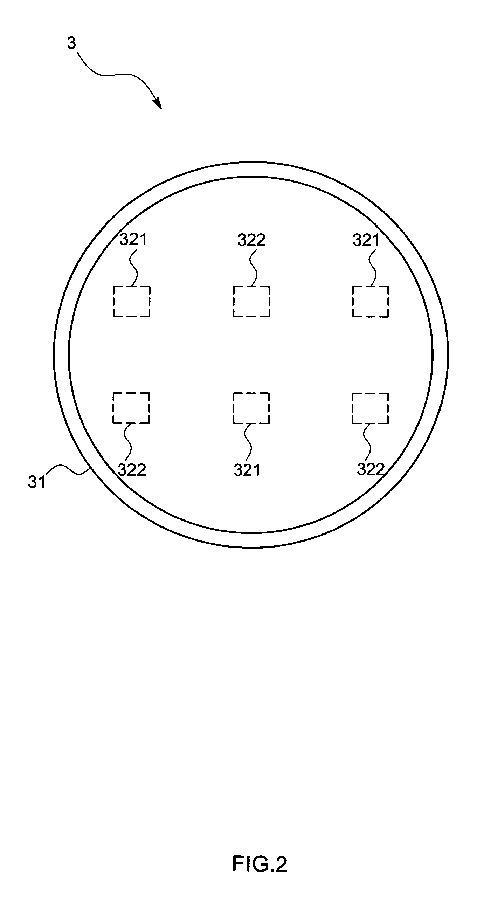

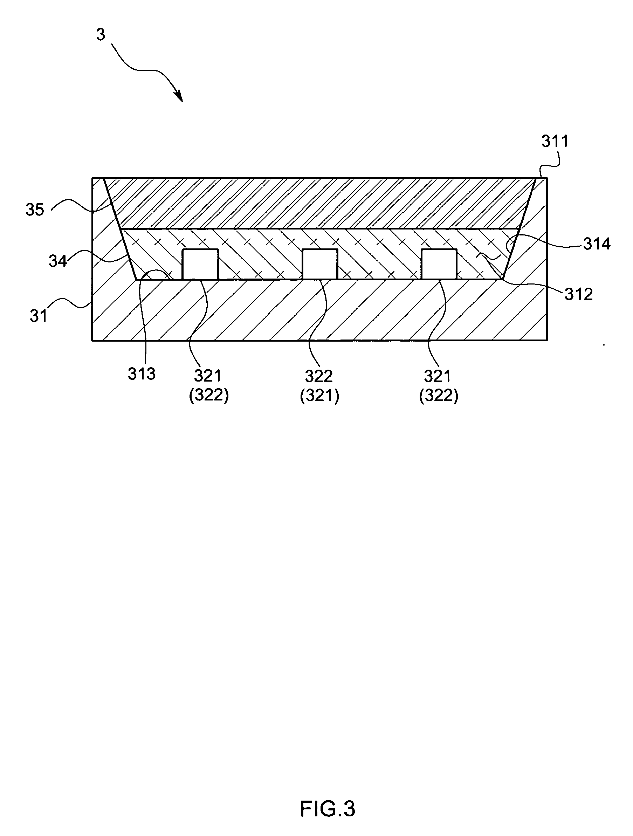

As shown in Figs. 2 and 3, the LED package 3 includes a base body 31 having a concave portion 312 formed to have an opening in a top surface 311 thereof, the first and second LED elements 321 and 322 installed on a bottom surface 313 of the concave portion 312, a light-transmitting member 34 for sealing the LED elements 321 and 322, and a wavelength converting member 35 containing fluorescent substances.

The base body 31 includes the concave portion 312 formed to have an opening in the top surface 311 and is composed by molding an insulating material having a high thermal conductivity such as, e.g., alumina or aluminum nitride.

The base body 31 like this is adapted to install the LED elements 321 and 322 on the bottom surface 313 of the concave portion 312 to be described later, and wiring conductors (not shown) are formed on the bottom surface 313 for electrically connecting the LED elements 321 and 322. The wiring conductors are derived to an outer surface of the light emitting device 1 via a wiring layer (not shown) formed inside the base body 31 so as to be connected to an outer electric circuit board. Thus, the LED elements 321 and 322 and the outer electric circuit board are electrically connected.

Moreover, the inner surface of the base body 31 including a side surface 314 and the bottom surface 313 of the concave portion 312 is coated with metal such as silver, aluminum, gold and the like so as to form a metal thin film of a high reflectance that functions as a reflector.

Each of the LED elements 321 and 322 is adapted to emit ultraviolet rays or short-wavelength visible rays each having a radiation peak at a wavelength of, e.g., 200 to 430 nm. Each of the LED elements 321 and 322 is composed of, e.g., gallium nitride based compound semiconductors formed by laminating an n-type layer, a light emitting layer and a p-type layer in this order on a sapphire substrate or a gallium nitride substrate.

The radiation peaks of the first LED elements 321 and the second LED elements 322 are different from each other, and a combination of, for example, an LED element having a radiation peak of 395 nm and an LED element having a radiation peak of 410 nm may be used, or a combination of an LED element having a radiation peak of 365 nm and an LED element having a radiation peak of 405 nm may be used. In the present embodiment, three pieces of the respective LED elements 321 and 322 are used, and these elements are alternately arranged (in a staggered arrangement) on the bottom surface 313 of the concave portion 312 in the same base body 31.

These LED elements 321 and 322 are installed in a flip-chip mounting manner using a solder bump or a gold bump etc. (not shown) on the bottom surface 313 of the concave portion 312 with the gallium nitride based compound semiconductors situated downward (toward a side of the bottom surface 313 of the concave portion 312). Thus, the LED elements 321 and 322 having different wavelengths individually constitute independent circuits.

The light-transmitting member 34 is filled in the concave portion 312 to seal the LED elements 321 and 322, and it includes such as, e.g., a silicon resin having an excellent translucency and heat-resistance with a small difference in refractive index from those of the LED elements 321 and 322. With provision of the light-transmitting member 34 like this, an efficiency of deriving light from the LED elements 321 and 322 can be improved so as to prevent heat deterioration of the fluorescent substances.

The wavelength converting member 35 is provided on the light-transmitting member 34 and contains red, green and blue fluorescent substances inside thereof. As the red fluorescent substance, there is exemplified, e.g., a europium activation silicon acid nitride fluorescent substance having a light emission peak wavelength of 640 nm, as the green fluorescent substance, there is exemplified, e.g., a europium activation silicate fluorescent substance having a light emission peak wavelength of 530 nm, and as the blue fluorescent substance, there is exemplified, e.g., a europium activation aluminate fluorescent substance having a light emission peak wavelength of 460 nm.

As the wavelength converting member 35 like this, there is exemplified a silicon resin dispersed with fluorescent substances inside thereof and having an excellent translucency and heat resistance and having a small difference in refractive index from that of the light-transmitting member 34. However, it may be configured by filling an uncured silicon resin dispersed with the fluorescent substances in the concave portion 312, or it may be configured by cutting a processed sheet-shaped one to have a prescribed size to be used.

Each of the variable resistors 41 and 42 is configure to have three terminals having a constant resistance between the both end terminals and having a variable resistance between a central terminal and the both end terminals by rotating an axis. Thus, current amounts $I_1$ and $I_2$ flowing to the LED elements 321 and 322 are reversibly adjusted.

The control unit 5 may be constructed of a digital and analog electric circuit including a CPU or a memory, an A/D converter, a D/A converter etc. or may be exclusive one, or may be adapted to use a general-purpose computer such as a personal computer for a part or an entire part. Alternatively, it may be constructed so as to function as each of the parts only by an analog circuit without using a CPU, or it is not necessary to be physically integrated but it may be constructed of a plurality of units which are mutually connected via wiring or wireless.

Thus, a prescribed program is stored in the memory so as to operate the CPU and the peripheral equipment thereof in cooperation according to the program to thereby perform the functions of at least a color temperature receiving part 51, a light quantity receiving part 52 and a current control part 53.

The color temperature receiving part 51 is provided with, e.g., a dial so as to receive color temperature data having a color temperature value selected in a range of 1800 to 16000 K by rotating the dial.

The light quantity receiving part 52 is provided with, e.g., a dial so as to receive light quantity data having a light quantity value (i.e., luminous intensity) selected by rotating the dial.

The current control part 53 acquires the color temperature data from the color temperature receiving part 51 and the light quantity data from the light quantity receiving part 52, respectively, and generates a control signal based on the color temperature data and the light quantity data so that the control signal is transmitted to the respective variable resistors 41 and 42 so as to adjust the resistance values.

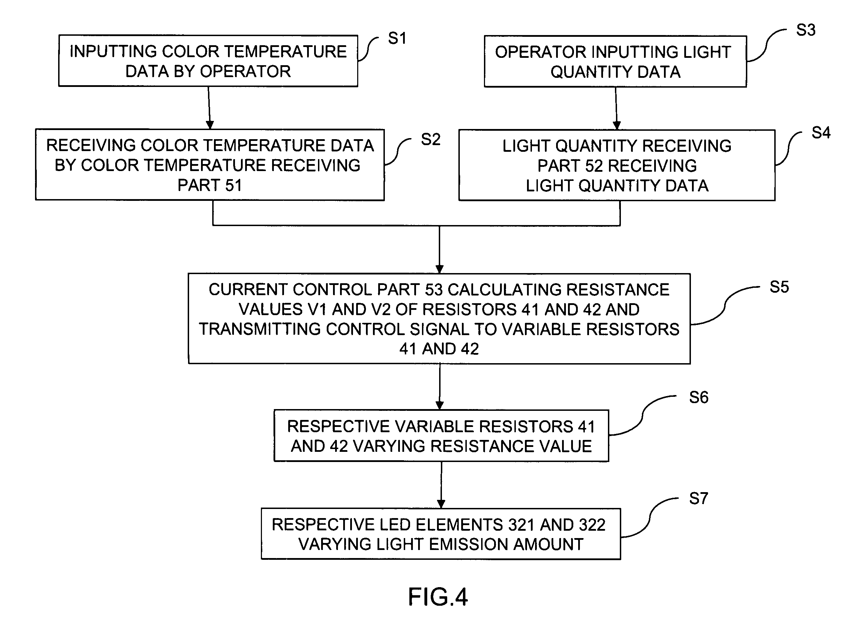

Next, the following describes a method of adjusting the color temperature and light quantity of the white light emitted by the LED package 3 using the light emitting device 1 according to the flowchart of Fig. 4.

Initially, an operator rotates the dial to thereby input color temperature data having a prescribed color temperature value (Step S1) so that the color temperature receiving part 51 receives the color temperature data (Step S2).

Similarly, the operator rotates the dial to thereby input light quantity data having a prescribed light quantity value (Step S3) so that the light quantity receiving part 52 receives the light quantity data (Step S4).

The current control part 53 acquires the color temperature data from the color temperature receiving part 51 and the light quantity data from the light quantity receiving part 52, respectively, and performs a predetermined calculation process based on the color temperature data and light quantity data so as to calculate a ratio $I_1 : I_2$ of current values flowing to the respective LED elements 321 and 322 and a total current value $I_1 + I_2$ of the currents flowing to the respective LED elements 321 and 322. Thus, the current control part 53 further calculates the resistance values $V_1$ and $V_2$ of the respective variable resistors 41 and 42 so as to generate a control signal having the resistance values $V_1$ and $V_2$ so that the control signal is transmitted to the respective variable resistors 41 and 42 (Step S5).

The respective variable resistors 41 and 42 receive the control signal so that the resistance values $V_1$ and $V_2$ are varied in accordance with the control signal (Step S6).

When the resistance values $V_1$ and $V_2$ of the respective variable resistors 41 and 42 are varied, the current values $I_1$ and $I_2$ of the currents flowing to the respective LED elements 321 and 322 are varied so as to vary the light quantity values of the light emitted by the respective LED elements 321 and 322 (Step S7).

As a result, the color temperature and light quantity of the white light emitted by the LED package 3 is controlled.

With the light emitting device 1 according to the embodiment as described above, since the ultraviolet rays or short-wavelength visible rays of different wavelengths emitted from the two kinds of LED elements 321 and 322 installed on the same base body 31 are converted by the same wavelength converting member 35, two kinds of white light having different color temperatures are excellently mixed to each other inside the same package 3 so as to be able to obtain natural white light having a color temperature variable along a black-body locus or the vicinity thereof.

That is, an excitation efficiency of the blue fluorescent substances (i.e., conversion efficiency to blue light) differs according to a wavelength of the ultraviolet rays or short-wavelength visible rays serving as excitation light, and the green fluorescent substances are also excited by the blue light in addition to the ultraviolet rays or short-wavelength visible rays, and the red fluorescent substances are also excited by the blue light and green light in addition to the ultraviolet rays or short-wavelength visible rays. Therefore, if the blue fluorescent substances, the green fluorescent substances and the red fluorescent substances are used in combination, as the light intensity of the blue light emitted from the blue fluorescent substances is varied, the light intensities of the green and red light emitted from the green and red fluorescent substances are also varied, and therefore the natural white light having different color temperatures can be obtained. Hence, by mixing these kinds of light, there can be obtained white light having a color temperature varying along the black-body locus or the vicinity thereof.

Further, according to the present embodiment, since the color temperature of the white light can be adjusted by a single package 3 accommodating the two LED elements 321 and 322, it becomes possible to miniaturize the light emitting device compared to the conventional light emitting device in which the color temperature of the white light is adjusted using a plurality of kinds of packages respectively having different distributions of the fluorescent substances, and hence the manufacturing cost can be accordingly reduced.

In addition, the present invention is not limited to the above embodiment.

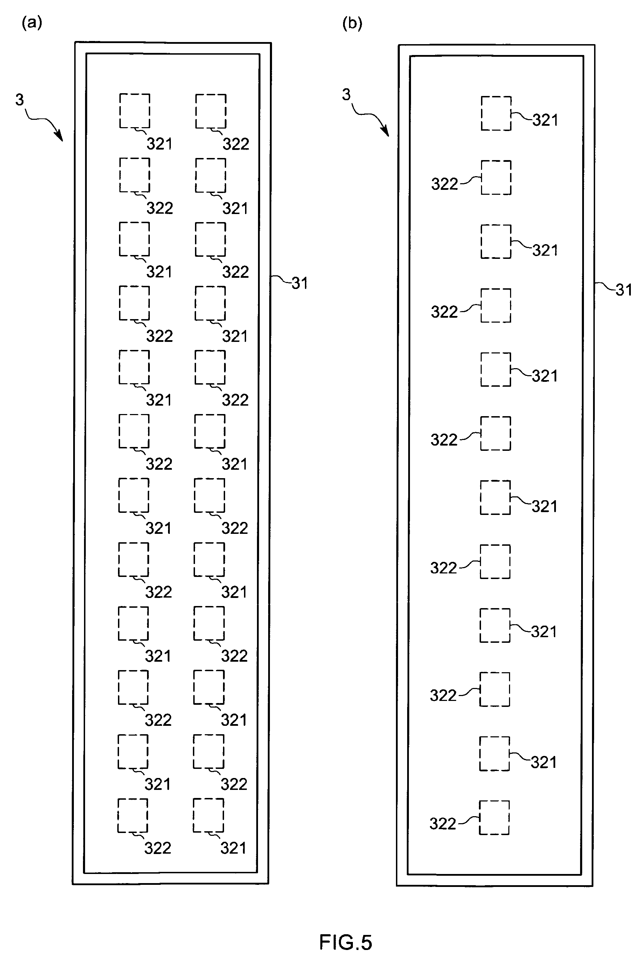

For example, the LED package 3 may be configured such that the LED elements 321 and 322 are alternately arranged on the same long-sized substrate as shown in Figs. 5 (a) and (b). With this configuration, it can be used as a substitute for a fluorescent tube having a dimming function.

Moreover, as a current control method (dimming scheme), it is not limited in particular to the above example, and there may be used, for example, (1) constant-current dimming by a variable current source, (2) constant-voltage dimming by a variable voltage source and a limiting resistor, (3) pulse width dimming or PWM dimming using a constant or variable voltage source and a limiting resistor, and (4) pulse width dimming or PWM dimming using a constant or variable current source and a limiting resistor, and the like.

The fluorescent substances contained in the wavelength converting member 35 are not limited in particular to the blue, green and red fluorescent substances, and a combination of blue fluorescent substances and yellow fluorescent substances may be used.

The LED elements for use in the LED package 3 are not limited to two kinds, but three or more kinds may be used. Also, the setting number of the LED elements of each kind may be respectively one, or may be respectively two or more.

Further, it is not necessary that the LED elements of the same kind are mutually connected in series, and the LED elements may be connected in parallel, or may be connected in series and in parallel in combination.

The LED elements 321 and 322 may be connected to the wiring conductors provided on the base body 31 using wire bonding.

The light emitting device pertaining to the present invention may not be provided with a variable resistor, and as a simpler configuration, for example, a control circuit may be provided so as to be able to perform ON/OFF control respectively for each of the LED elements of a plurality of kinds emitting light of different wavelengths. With this configuration, in the case of using the LED elements each having a color temperature A and the LED elements each having a color temperature B of the white light emitted by the excited wavelength converting member, white light having the color temperatures A and B originated by the respective LED elements and white light having an intermediate color temperature C between A and B can be outputted by an ON/OFF combination so that the color temperature of the white light emitted by the light emitting device can be varied in three methods. In this case, a switch may be sufficient such that, only the LED elements having the color temperature A is switched ON, only the LED elements having the color temperature B is switched ON, both of them are switched ON, and both of them are switched OFF. In the case where such a control circuit capable of performing ON/OFF control of the respective LED elements is used as the current control part, assuming that n kinds of LED elements are used, the kinds of the color temperatures can be controlled in maximum by Equation 1 as below.

[Equation 1]

$$\sum_{i=1}^{n} {}_nC_i$$

Herein, $_nC_i$ is a symbol representing a combination of selecting different i pieces from different n pieces.

In addition, the present invention is not limited to each of the above embodiments and various components thereof described above may be partially or entirely combined appropriately.

Industrial Applicability

According to the light emitting device pertaining to the present invention, since the color temperature of the white light can be varied along the black-body locus or the vicinity thereof, it is possible to obtain light having excellent color rendering properties.

Reference Signs List

| | |
|---|---|
| 1 ... | Light emitting device |
| 31... | Base body |
| 321, 322 ... | LED element |
| 35 ... | Wavelength converting member |
| 53 ... | Current control part |

**Claims**

1. A light emitting device, comprising:

    a plurality of kinds of LED elements emitting ultraviolet rays or short-wavelength visible rays of different wavelengths;
    a single wavelength converting member containing fluorescent substances and converting the ultraviolet rays or short-wavelength visible rays emitted from the plurality of kinds of LED elements to derive white light; and
    a current control part varying current values to be supplied to the plurality of kinds of LED elements.

2. The light emitting device according to claim 1, wherein each of the LED elements has a radiation peak at a wavelength of 200 to 430 nm.

3. The light emitting device according to claim 1, wherein the plurality of kinds of LED elements are alternately arranged on the same base member.

4. The light emitting device according to claim 1, wherein the fluorescent substances include fluorescent substances emitting red light, fluorescent substances emitting green light and fluorescent substances emitting blue light.

5. The light emitting device according to claim 1 emitting white light having a color temperature varying along a black-body locus or the vicinity thereof.

FIG.1

FIG.2

FIG.3

```
┌─────────────────────────────┐ S1          ┌─────────────────────────────┐ S3
│ INPUTTING COLOR TEMPERATURE │             │  OPERATOR INPUTTING LIGHT   │
│      DATA BY OPERATOR        │             │       QUANTITY DATA         │
└─────────────────────────────┘             └─────────────────────────────┘
              │                                            │
              ▼                                            ▼
┌─────────────────────────────┐ S2          ┌─────────────────────────────┐ S4
│ RECEIVING COLOR TEMPERATURE │             │   LIGHT QUANTITY RECEIVING  │
│  DATA BY COLOR TEMPERATURE   │             │       PART 52 RECEIVING     │
│     RECEIVING PART 51        │             │     LIGHT QUANTITY DATA     │
└─────────────────────────────┘             └─────────────────────────────┘
              │                                            │
              └──────────────────┬─────────────────────────┘
                                 ▼
          ┌─────────────────────────────────────────────┐ S5
          │ CURRENT CONTROL PART 53 CALCULATING RESISTANCE │
          │   VALUES V1 AND V2 OF RESISTORS 41 AND 42 AND  │
          │ TRANSMITTING CONTROL SIGNAL TO VARIABLE RESISTORS │
          │                  41 AND 42                      │
          └─────────────────────────────────────────────┘
                                 │
                                 ▼
             ┌─────────────────────────────────────┐ S6
             │ RESPECTIVE VARIABLE RESISTORS 41      │
             │ AND 42 VARYING RESISTANCE VALUE       │
             └─────────────────────────────────────┘
                                 │
                                 ▼
             ┌─────────────────────────────────────┐ S7
             │ RESPECTIVE LED ELEMENTS 321 AND 322   │
             │    VARYING LIGHT EMISSION AMOUNT      │
             └─────────────────────────────────────┘
```

FIG.4

(a)

(b)

3

321
322

322
321

321
322

322
321

321
322

322
321

321
322

322
321

321
322

322
321

321
322

322
321

31

3

321

322
321

322
321

322
321

322
321

322
321

322
321

322
321

322
321

322
321

322
321

31

FIG.5

| INTERNATIONAL SEARCH REPORT | | International application No. |
|---|---|---|
| | | PCT/JP2010/061424 |

**A. CLASSIFICATION OF SUBJECT MATTER**
*H01L33/50*(2010.01)i, *H01L33/00*(2010.01)i, *H05B37/02*(2006.01)i

According to International Patent Classification (IPC) or to both national classification and IPC

**B. FIELDS SEARCHED**

Minimum documentation searched (classification system followed by classification symbols)
H01L33/00-33/64, H05B37/02

Documentation searched other than minimum documentation to the extent that such documents are included in the fields searched
Jitsuyo Shinan Koho        1922-1996   Jitsuyo Shinan Toroku Koho   1996-2010
Kokai Jitsuyo Shinan Koho   1971-2010   Toroku Jitsuyo Shinan Koho   1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2005-136005 A  (Matsushita Electric Works, Ltd.), 26 May 2005 (26.05.2005), paragraphs [0027], [0044], [0045]; fig. 9 (Family: none) | 1-5 |
| A | JP 2008-258356 A  (Sharp Corp.), 23 October 2008 (23.10.2008), entire text; all drawings (Family: none) | 1-5 |

☒ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 July, 2010 (23.07.10) | 03 August, 2010 (03.08.10) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2010/061424

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2007-288139 A  (Sumitomo Chemical Co., Ltd.), 01 November 2007 (01.11.2007), entire text; all drawings & US 2009/0166644 A1    & GB 2451201 A & WO 2007/111359 A1    & KR 10-2008-0113049 A & CN 101449401 A | 1-5 |
| A | JP 2008-235680 A  (Toshiba Lighting & Technology Corp.), 02 October 2008 (02.10.2008), entire text; all drawings (Family: none) | 1-5 |
| A | JP 2001-209049 A  (Sony Corp.), 03 August 2001 (03.08.2001), entire text; all drawings (Family: none) | 1-5 |
| A | JP 2002-134284 A  (Stanley Electric Co., Ltd.), 10 May 2002 (10.05.2002), entire text; all drawings (Family: none) | 1-5 |
| P,X | JP 2009-267239 A  (Toyoda Gosei Co., Ltd.), 12 November 2009 (12.11.2009), entire text; all drawings (Family: none) | 1-5 |

Form PCT/ISA/210 (continuation of second sheet) (July 2009)

**EP 2 453 489 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004006253 A